# EUROPEAN PATENT APPLICATION

(11) **EP 4 412 420 A1**
(43) Date of publication of application: **07.08.2024**
(21) Application number: 22875495.8
(22) Date of filing: 21.06.2022
(51) Int. Cl.: H05K 13/04, H05K 13/08

(54) **MOUNTING MACHINE AND SUCTION STATE DETERMINATION METHOD**

(30) Priority: 30.09.2021 JP 2021161402
(71) Applicant: Panasonic Intellectual Property Management Co., Ltd., Kadoma-shi, Osaka 571-0057 (JP)
(72) Inventor: SHIBATA Satoru, Kadoma-shi, Osaka 571-0057 (JP); KITADA Takashi, Kadoma-shi, Osaka 571-0057 (JP)
(74) Representative: Eisenführ Speiser
(86) International application number: PCT/JP2022/024723
(87) International publication number: WO 2023/053616

(57) **Abstract**

A mounting machine includes a head that includes a suction nozzle, the head being configured to suck a component at a distal end portion of the suction nozzle and mount the component on a board, a sensor that includes a light source and a light receiver, the light source being configured to emit a light ray to the distal end portion of the suction nozzle, the light receiver being configured to receive the light ray emitted from the light source, the sensor being configured to output light intensity of the light ray received by the light receiver, and a controller that computes a first differential value by differentiating the light intensity of the light ray output from the sensor, and determines whether or not a suction state of the component sucked to the distal end portion of the suction nozzle when the suction nozzle passes through the light ray is defective based on the computed first differential value. The controller determines that the suction state of the component is not defective when the first differential value is more than or equal to a first threshold value and is less than a second threshold value more than the first threshold value.

## Description

### TECHNICAL FIELD

The present disclosure relates to a mounting machine and a suction state determination method.

### BACKGROUND ART

PTL 1 discloses a component mounting method for positioning a suction nozzle holding a component at a distal end portion at a predetermined position of component mounting device information on an attached object, lowering the suction nozzle from the predetermined position to mount the component on a component mounting position, and releasing the holding of the component by the suction nozzle to raise the suction nozzle. In the component mounting method, a measurement position is set at a predetermined height position of a raising and lowering path of the suction nozzle, a time taken for the component or the suction nozzle to reach the measurement position from the predetermined position is measured when the suction nozzle is lowered and/or raised, and whether or not a holding state and/or a mounting state of the component by the suction nozzle is favorable is determined based on the measured time.

### Citation List

### Patent Literature

PTL 1: Unexamined Japanese Patent Publication No. 2002-208800

### SUMMARY OF THE INVENTION

The present disclosure has been made in view of the above-described conventional circumstances, and an object of the present disclosure is to provide a mounting machine and a suction state determination method for acquiring a suction state of a component sucked by a nozzle with higher accuracy.

A mounting machine according to the present disclosure includes a head that includes a suction nozzle, the head being configured to suck a component at a distal end portion of the suction nozzle and mount the component on a board, a sensor that includes a light source and a light receiver, the light source being configured to emit a light ray to the distal end portion of the suction nozzle, the light receiver being configured to receive the light ray emitted from the light source, the sensor being configured to output light intensity of the light ray received by the light receiver, and a controller that computes a first differential value by differentiating the light intensity of the light ray output from the sensor, and determines whether or not a suction state of the component sucked to the distal end portion of the suction nozzle when the suction nozzle passes through the light ray is defective based on the computed first differential value. The controller determines that the suction state of the component is not defective when the first differential value is more than or equal to a first threshold value and is less than a second threshold value more than the first threshold value.

In addition, a suction state determination method according to the present disclosure is a suction state determination method executed by a terminal device including one or more computers connected to communicate with a mounting machine, the mounting machine being configured to suck a component at a distal end portion of a suction nozzle and mount the component on a board. The method includes acquiring light intensity of a light ray emitted to the distal end portion of the suction nozzle and received by a light receiver, computing a differential value by differentiating the acquired light intensity of the light ray, and determining that a suction state of the component sucked to the distal end portion of the suction nozzle when the suction nozzle passes through the light ray is not defective when it is determined that the computed differential value is more than or equal to a first threshold value and is less than a second threshold value more than the first threshold value.

According to the present disclosure, the suction state of the component sucked by the nozzle can be determined with higher accuracy.

### BRIEF DESCRIPTION OF THE DRAWINGS

Fig. 1 is a block diagram illustrating an internal configuration example of a mounting machine according to a first exemplary embodiment.
Fig. 2 is a diagram for describing a partial configuration example of the mounting machine according to the first exemplary embodiment.
Fig. 3 is an enlarged view of main parts of the mounting machine.
Fig. 4 is a diagram for describing an example of IV conversion processing.
Fig. 5 is a diagram for describing a determination processing example of a suction state of a component in the mounting machine according to the first exemplary embodiment.
Fig. 6 is a diagram for describing a determination processing example of a suction posture (angle) of a component of the mounting machine according to the first exemplary embodiment.
Fig. 7 is a diagram for describing a comparative example of an IV conversion graph and a differential graph depending on the presence or absence of disturbance.

### DESCRIPTION OF EMBODIMENT

### (Background to the present disclosure)

In the related art, there is a mounting machine that detects an electronic component (hereinafter, referred to as a "component") sucked to a distal end portion of a suction nozzle by using an optical sensor and determines whether or not a suction state of the component is favorable. The component mounting method and the device (hereinafter, referred to as a "mounting machine") of PTL 1 compute the passing time at the time of lowering shielded by the suction nozzle and the component by using the optical sensor disposed to be able to detect the suction nozzle and the component in a range corresponding to the component mounting position on the circuit board (hereinafter, referred to as a "board"). In addition, the mounting machine computes the theoretical value of the passing time at the time of lowering based on each of the lowering speed of the suction nozzle, the thickness of the component, and the offset amount of the suction nozzle that are stored in advance, and determines that the component is normally sucked in a case where it is determined that (passing time at the time of lowering) ≈ (theoretical value of passing time at the time of lowering).

However, in the component mounting method described above, the theoretical value of the passing time at the time of lowering is calculated by using the offset amount of the suction nozzle stored in advance. Thus, in the mounting machine, in a case where there is deterioration of the suction nozzle such as wear, the passing time at the time of lowering is shortened, and thus, there is a possibility that the determination accuracy of the suction posture of the component decreases.

In addition, as another method for performing whether or not the suction state of the component is favorable by using the optical sensor, there is a method for determining the suction state of the component conveyed by the suction nozzle by the optical sensor provided in the conveyance path of the component from the component supply position to the component mounting position. The mounting machine shields the light of the light source by the suction nozzle and component passing through the optical sensor, calculates the thickness of the component based on the light shielding amount, and determines the suction state of the component. However, in such a method, since the light shielding amount changes due to the individual difference (for example, nozzle length) in the raising-lowering direction of the suction nozzle, the mounting machine has a possibility that the measurement accuracy of the thickness of the sucked component decreases and the determination accuracy of the suction posture of the component decreases.

Hereinafter, each exemplary embodiment specifically disclosing a configuration and an action of a mounting machine and a suction state determination method according to the present disclosure will be described in detail with reference to the drawings as appropriate. It is noted that a more detailed description than need may be omitted. For example, a detailed description of a well-known matter and a repeated description of substantially an identical configuration may be omitted. This is to avoid the unnecessary redundancy in the following description and to make the descriptions easier to understand for those skilled in the art. Note that, the accompanying drawings and the following description are provided for those skilled in the art to fully understand the present disclosure, and are not intended to limit the subject matter described in the scope of claims.

In addition, hereinafter, in each drawing, an X-direction and a Y-direction are directions orthogonal to each other in a horizontal plane. A Z-direction is a height direction (up-down direction) orthogonal to the X-direction and the Y-direction.

### (First exemplary embodiment)

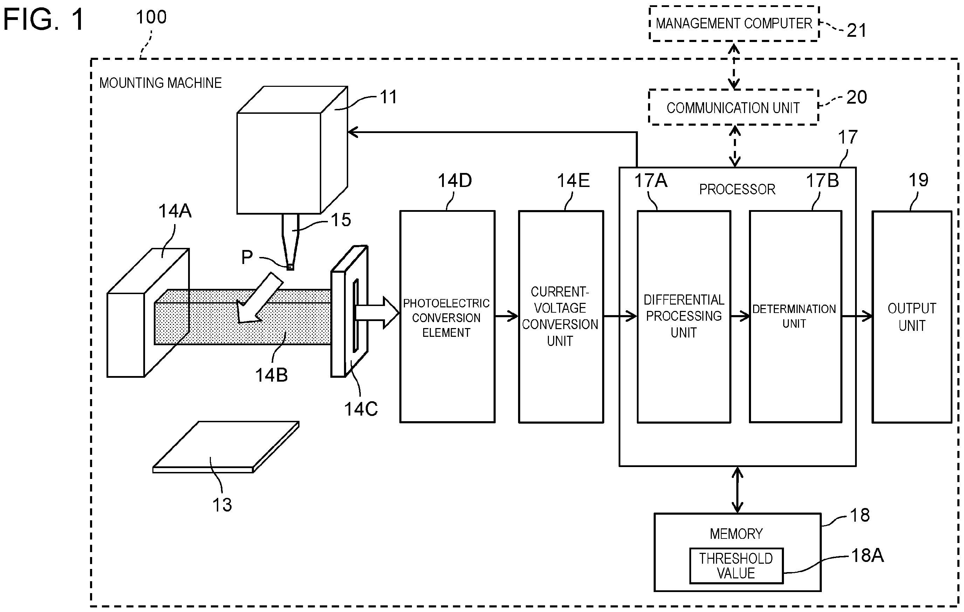

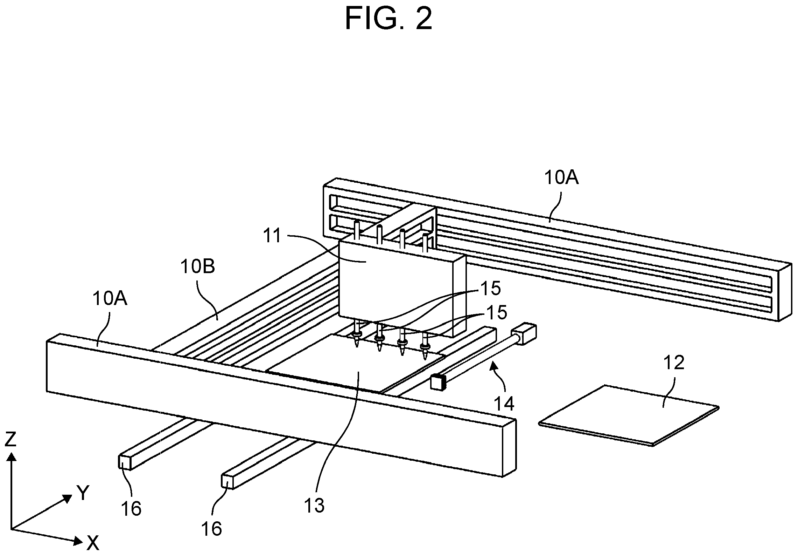

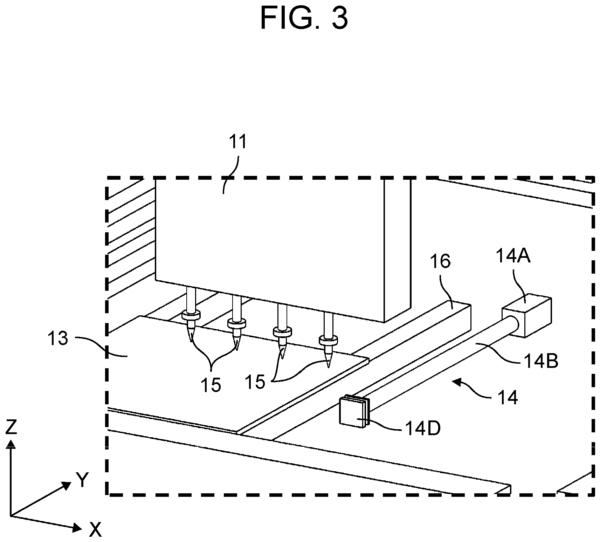

First, an internal configuration of mounting machine 100 according to a first exemplary embodiment will be described with reference to Figs. 1 to 3. Fig. 1 is a diagram for describing an internal configuration example of mounting machine 100 according to the first exemplary embodiment. Fig. 2 is a diagram for describing a partial configuration example of mounting machine 100 according to the first exemplary embodiment. Fig. 3 is an enlarged view of main parts of mounting machine 100.

Note that, in the example illustrated in Fig. 1, the number of mounting machines connected to management computer 21 is one, but a plurality of mounting machines may be simultaneously connected. In addition, in Fig. 1, X-axis rails 10A, Y-axis rail 10B, component supply unit 12, and board rails 16 are not illustrated.

Mounting machine 100 according to the first exemplary embodiment drives the pair of board rails 16 to load board 13. Mounting machine 100 drives head 11 including one or more suction nozzles 15 to cause each of suction nozzles 15 to suck component P (see Fig. 3) supplied by component supply unit 12. After component P is sucked by suction nozzle 15, mounting machine 100 moves head 11 onto board 13 to convey component P onto board 13, and then mounts component P at each component mounting position on board 13. Mounting machine 100 mounts (attaches) all the components P to be mounted on board 13 to produce a mounting board, and then drives each of the pair of board rails 16 to unload the produced mounting board.

Mounting machine 100 includes head 11, component supply unit 12, measurement system 14, one or more suction nozzles 15, the pair of board rails 16, processor 17, memory 18, and output unit 19. Note that, communication unit 20 is not an essential component and may be omitted. In addition, in a case where mounting machine 100 includes communication unit 20, the mounting machine may be connected to communicate with management computer 21 (that is, external device) to execute transmission and reception of data.

The pair of X-axis rails 10A is combined with Y-axis rail 10B, and supports Y-axis rail 10B to be movable in the X-direction and a -X-direction. Y-axis rail 10B is combined with head 11, and supports head 11 to be movable in the Y-direction and a -Y-direction. The pair of X-axis rails 10A and Y-axis rail 10B constitute a moving mechanism that moves head 11.

Head 11 is driven (moved) in each of the X-axis direction, the Y-axis direction, and the Z-axis direction under the control of the moving mechanism. Head 11 is combined with Y-axis rail 10B, and conveys component P between component supply unit 12 and a predetermined component mounting position on board 13.

Head 11 includes one or more suction nozzles 15. Head 11 causes processor 17 to execute suction and suction release of component P by each of suction nozzles 15. Head 11 mounts component P on board 13 by sucking component P supplied by component supply unit 12 at a distal end portion of suction nozzle 15, conveys component P to a predetermined component mounting position on board 13, and then releases the suction of the component.

Here, in head 11, after component P is sucked, component P sucked to the distal end portion of suction nozzle 15 is disposed between component supply unit 12 and board 13, and moves to pass through light ray 14B emitted from light source 14A. Thus, mounting machine 100 measures a thickness of component P sucked to the distal end portion of each suction nozzle 15 based on a light shielding amount of light ray 14B, and determines a suction state of component P. In one example, as illustrated in Fig. 3, the plurality of suction nozzles 15 are aligned in a direction orthogonal to a direction in which light source 14A emits light ray 14B. In addition, head 11 is configured to move in a direction in which the plurality of suction nozzles 15 are aligned.

Component supply unit 12 is controlled by processor 17 to supply component P mounted on board 13. Note that, component supply unit 12 may be able to simultaneously supply a plurality of different types of components P. In addition, the disposition of component supply unit 12 illustrated in Fig. 2 is an example and is not limited thereto.

Measurement system 14 as an example of a sensor includes light source 14A, slit 14C, photoelectric conversion element 14D, and current-voltage conversion unit 14E. Slit 14C is disposed on a surface facing light source 14A. Note that, a disposition position of measurement system 14 illustrated in each of Figs. 1 to 3 is an example and is not limited thereto.

For example, photoelectric conversion element 14D as an example of a light receiver converts light (light ray 14B) emitted from light source 14A such as a light emitting diode (LED) or a laser diode (LD) and passing through slit 14C into an electric signal, and outputs the electric signal to current-voltage conversion unit 14E. Current-voltage conversion unit 14E outputs a converted value (hereinafter, referred to as a "IV converted value") obtained by converting the electric signal (current) output from photoelectric conversion element 14D into a voltage to differential processing unit 17A in processor 17. Note that, current-voltage conversion unit 14E outputs the IV converted value to differential processing unit 17A at a predetermined cycle (for example, a cycle in the order of kHz). That is, current-voltage conversion unit 14E outputs the IV converted value at a frequency (first frequency) more than or equal to 1 kHz and is less than 1 MHz.

Processor 17 as an example of a controller is, for example, a central processing unit (CPU), a digital signal processor (DSP), or a field-programmable gate array (FPGA), and controls operations of units of processor 17. Processor 17 performs various kinds of processing and control in an integrated manner in cooperation with memory 18. Specifically, processor 17 realizes functions of the units by referring to a program and data retained in memory 18 and executing the program. Note that, the units mentioned here are differential processing unit 17A and determination unit 17B.

Differential processing unit 17A computes a differential (difference) of each of two consecutive IV converted values output from current-voltage conversion unit 14E. Differential processing unit 17A outputs the differential values of the computed IV converted values to determination unit 17B.

Determination unit 17B measures a thickness (height) in the Z-direction, a width in the X-direction, a posture (angle), and the like of component P sucked to the distal end portion of suction nozzle 15 based on a time-series change in the differential value output from differential processing unit 17A, and executes determination processing related to a suction state or a suction posture of component P. Determination unit 17B determines whether or not the thickness of component P sucked by each suction nozzle 15 is a thickness of component P in a case where component P is normally sucked based on the differential values output from differential processing unit 17A and threshold value 18A stored in memory 18. In addition, determination unit 17B determines whether or not the suction posture (angle) of component P sucked by each suction nozzle 15 is a suction posture of component P in a case where component P is normally sucked based on the differential values output from differential processing unit 17A and threshold value 18A stored in memory 18.

Determination unit 17B outputs the determination result to output unit 19. Note that, determination unit 17B may output the determination result to output unit 19 only in a case where it is determined that component P is not normally sucked or is not in the normal suction posture. In addition, determination unit 17B may store the determination result in memory 18. Further, in a case where mounting machine 100 is connected to communicate with management computer 21 via communication unit 20, determination unit 17B may output the determination result to management computer 21 via communication unit 20.

Note that, in a case where it is determined that component P is normally sucked and is not in the normal suction posture, determination unit 17B may calculate an angular difference between the measured suction angle of component P and a normal suction angle, and may rotate corresponding suction nozzle 15 based on the calculated angular difference. Thus, mounting machine 100 can correct the suction posture (angle) of component P to the normal suction posture.

Memory 18 includes, for example, a random access memory (RAM) as a work memory used when each processing of processor 17 is executed, and a read only memory (ROM) that stores data and a program that defines an operation of processor 17. Data or information generated or acquired by processor 17 is temporarily stored in the RAM. The program that defines the operation of processor 17 is written to the ROM. Memory 18 stores threshold value 18A used for various kinds of determination executed by determination unit 17B. In addition, memory 18 stores production data for producing a mounting board to be produced.

The production data mentioned here is information used for producing the mounting board by mounting machine 100. The production data includes, for example, a size of board 13, a size and a shape of component P, information on the suction nozzle, the number of produced boards, and the like. Note that, the production data may not be limited to the data of the items described above. The production data may include information of threshold value 18A for each component P to be described later.

Threshold value 18A is set for each type of component P, and is a threshold value for determining whether or not component P is normally sucked by suction nozzle 15. Specifically, threshold value 18A stored in memory 18 includes threshold values (for example, a first threshold, a second threshold, a third threshold, a fourth threshold, and the like) for determining whether or not component P is normally sucked based on the thickness of component P, threshold values (for example, a fifth threshold and a sixth threshold) for determining whether or not the suction posture (angle) of component P is normal, and the like. Note that, at least one threshold value may be set as the threshold value used for each determination.

Output unit 19 is, for example, a display such as a liquid crystal display (LCD) or an organic electroluminescence (EL). Output unit 19 displays the determination result related to the suction state or the suction posture of component P output from determination unit 17B, or outputs sound.

Communication unit 20 is connected to communicate with management computer 21 in a wireless or wired manner to transmit and receive data. Communication unit 20 transmits the determination result related to the suction state or the suction posture of component P output from determination unit 17B to management computer 21. In addition, communication unit 20 acquires the production data of board 13, the production data for each component P, the threshold value for each component P, or the like transmitted from management computer 21, and outputs the data to processor 17. Note that, the wireless communication mentioned here is communication via a wireless local area network (LAN) such as Wi-Fi (registered trademark).

Note that, the determination processing related to the suction state or the suction posture (angle) of component P may be executed by management computer 21. In such a case, processor 17 in mounting machine 100 may transmit the IV converted value output from current-voltage conversion unit 14E and identification information capable of identifying mounting machine 100 and suction nozzle 15 to management computer 21 in association with each other, or may transmit the differential values computed by differential processing unit 17A and the identification information capable of identifying mounting machine 100 and suction nozzle 15 to management computer 21 in association with each other. In addition, in such a case, mounting machine 100 may acquire the determination result related to the suction state or the suction posture of component P transmitted from management computer 21, may store the determination result in memory 18, and may output the determination result to output unit 19.

Management computer 21 is, for example, a personal computer (PC), a notebook PC, a tablet terminal, or the like, and is operated by an operator. Management computer 21 is connected to communicate with one or more mounting machines, generates production information regarding a production process of a mounting board input or set in advance by the operator and an execution command for executing the production process, and transmits the production information and the execution command to each mounting machine.

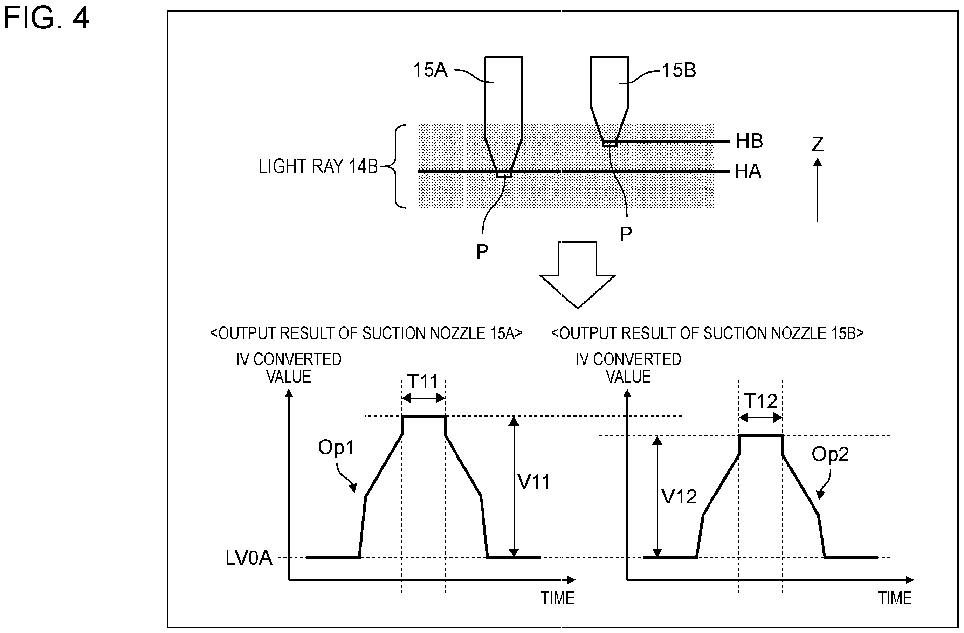

Next, IV (current-voltage) conversion processing executed by current-voltage conversion unit 14E will be described with reference to Fig. 4. Fig. 4 is a diagram for describing an example of the IV conversion processing. Note that, in Fig. 4, head 11 is not illustrated for easy understanding of the description.

Each of the plurality of suction nozzles 15 included in head 11 may have individual differences in a length to the distal end portion that sucks component P, a shape of the distal end portion, and the like due to a manufacturing error, aged deterioration, and the like. Hereinafter, a change in the IV conversion output value caused by the individual difference of suction nozzle 15 will be specifically described.

Here, in the example illustrated in Fig. 4, an example in which two suction nozzles 15A and 15B that suck identical components P are aligned along an emission direction (Y-direction) of light ray 14B is illustrated for easy understanding of description. However, as illustrated in Figs. 2 and 3, the plurality of actual suction nozzles 15 are disposed in a direction different from the emission direction (Y-direction) of light ray 14B such that two or more suction nozzles are not simultaneously detected by measurement system 14. Thus, mounting machine 100 can detect the suction state (or suction posture) of component P for each suction nozzle 15.

In the example illustrated in Fig. 4, suction nozzle 15A sucks component P at height HA. Suction nozzle 15B sucks component P at height HB. A light shielding amount of light ray 14B shielded by suction nozzle 15A is more than a light shielding amount of light ray 14B shielded by suction nozzle 15B.

IV conversion graph Op1 is a graph illustrating a time-series change in the IV converted value obtained when suction nozzle 15A passes through light ray 14B. IV conversion graph Op2 is a graph illustrating a time-series change in the IV converted value obtained when suction nozzle 15B passes through light ray 14B. A vertical axis of each of IV conversion graphs Op1 and Op2 indicates the IV converted value output from current-voltage conversion unit 14E. A horizontal axis of each of IV conversion graphs Op1 and Op2 indicates time. The IV converted value of each of IV conversion graphs Op1 and Op2 increases in proportion to the light shielding amount of light ray 14B. Light shielding level LV0A is an IV converted value indicating that light ray 14B is not shielded by the suction nozzle.

In such a case, in IV conversion graph Op1 corresponding to suction nozzle 15A, the light shielding amount is maximized by suction nozzle 15A and component P passing through light ray 14B in time zone T11, and the IV converted value becomes maximum value V11. In addition, similarly, in IV conversion graph Op2, the light shielding amount is maximized by suction nozzle 15A and component P passing through light ray 14B in time zone T12, and the IV converted value becomes maximum value V12. As described above, in a case where the light shielding amount of light ray 14B is different due to an individual difference between suction nozzles 15A and 15B, since mounting machine 100 has different IV converted values at the time of suction of component P indicated by IV conversion graphs Op1 and Op2, it is difficult to more accurately determine the suction state of component P.

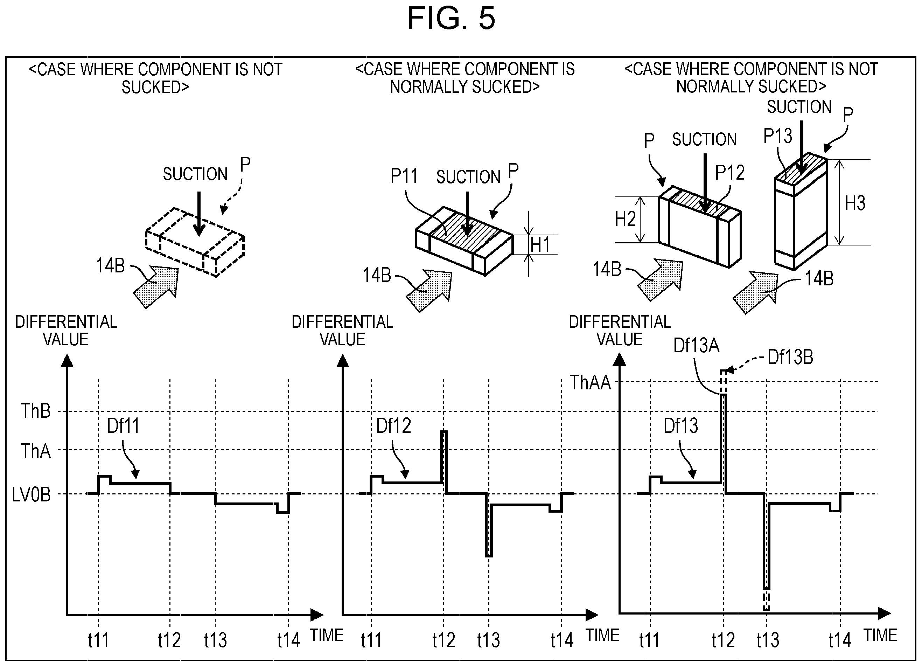

Therefore, mounting machine 100 according to the first exemplary embodiment differentiates two consecutive IV converted values output from current-voltage conversion unit 14E by differential processing unit 17A. Thus, mounting machine 100 can generate time-series data (for example, differential graphs Df11, Df12, Df13, Df14, and the like illustrated in Fig. 5) of differential values (differences) indicating change amounts of the IV converted values obtained by excluding the individual difference for each suction nozzle from the IV converted value. Hereinafter, examples of measurement processing of the thickness of component P and determination processing of the suction state of component P using the generated time-series data of the differential values will be described with reference to Fig. 5.

Next, the determination processing example of the suction state of component P executed by mounting machine 100 according to the first exemplary embodiment will be described with reference to Fig. 5. Fig. 5 is a diagram for describing the determination processing example of the suction state of component P in mounting machine 100 according to the first exemplary embodiment. Note that, in the example illustrated in Fig. 5, suction nozzle 15 is not illustrated. In addition, in the example illustrated in Fig. 5, the emission direction of light ray 14B is equal to an orientation of an arrow.

Differential processing unit 17A differentiates two consecutive IV converted values output from current-voltage conversion unit 14E, and acquires the differential values indicating the change amounts of these IV converted values. Differential processing unit 17A outputs the acquired differential values to determination unit 17B.

Determination unit 17B determines whether or not component P is normally sucked to the distal end portion of suction nozzle 15 based on the time-series changes (differential graphs) of the differential values output from differential processing unit 17A. Here, light ray 14B has a more light shielding amount as the thickness of component P increases. In addition, the obtained differential values increase as the light shielding amount of light ray 14B increases. Thus, determination unit 17B can measure the thickness of component P based on the differential values. Note that, in the description of Fig. 5 and subsequent drawings, the determination processing of the suction state of component P will be described by using the differential graph indicating the time-series changes of the differential values, but generation processing of the differential graph is not essential and may be omitted.

Determination unit 17B determines whether or not the differential value is more than or equal to first threshold value ThA and is less than second threshold value ThB. Here, first threshold value ThA is a threshold value regarding the differential value (that is, the thickness of component P), and is a threshold value for determining whether or not component P is sucked to the distal end portion of suction nozzle 15. Second threshold value ThB is a threshold value regarding the differential value (that is, the thickness of component P), is a value more than first threshold value ThA, and is a threshold value for determining whether or not component P is normally sucked to the distal end portion of suction nozzle 15.

In a case where it is determined that the differential value is less than first threshold value ThA, determination unit 17B determines that component P is not sucked to the distal end portion of suction nozzle 15. In a case where it is determined that the differential value is more than or equal to first threshold value ThA and is less than second threshold value ThB, determination unit 17B determines that component P is sucked to the distal end portion of suction nozzle 15 and component P is normally sucked. In addition, in a case where it is determined that the differential value is more than or equal to second threshold value ThB, determination unit 17B determines that component P is not normally sucked to the distal end portion of suction nozzle 15.

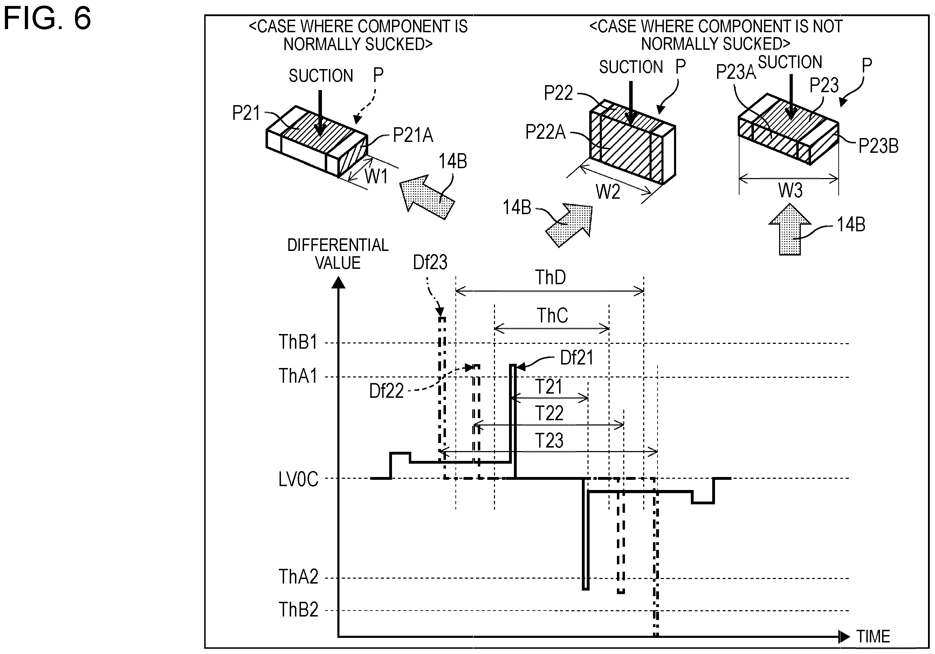

Note that, as illustrated in Fig. 6 to be described later, determination unit 17B may execute the determination processing of the suction state of component P based on a positive peak (maximum value) and a negative peak (minimum value) of the differential value.

Determination unit 17B outputs the determination result to output unit 19 or management computer 21, and stores the determination result in memory 18. Note that, various functions realized by differential processing unit 17A or determination unit 17B described above may be executed by management computer 21.

Hereinafter, the determination processing example of the suction state of component P by determination unit 17B will be specifically described by comparing differential graphs Df11 to Df14 illustrated in Fig. 5. Note that, the normal suction in the example illustrated in Fig. 5 is, for example, a state where surface P11 of component P is sucked by suction nozzle 15 and thickness H1 (height) of component P is detected by measurement system 14. Differential graph Df11 is an example of a differential graph in a case where component P is not sucked by suction nozzle 15. Differential graph Df12 is an example of a differential graph in a case where component P is normally sucked by suction nozzle 15. Each of differential graphs Df13 and Df14 is an example of a differential graph in a case where component P is not normally sucked by suction nozzle 15.

A vertical axis of each of differential graphs Df11 to Df14 indicates the differential value output from differential processing unit 17A. horizontal axis of each of differential graphs Df11 to Df14 indicates time. In addition, level LV0B indicates that the differential value output from the differential processing unit 17A is 0 (zero). Note that, in Fig. 5, an example in which suction nozzle 15 is detected between time t11 and time t14 and component P is detected between time t12 and time t13 will be described for easy understanding of the description. Note that, a period between time t11 and time 114 is also referred to as a predetermined period.

Differential graph Df11 is a differential graph in a case where suction nozzle 15 is not sucking component P. In differential graph Df11, between time t12 and time t13, only the distal end portion of suction nozzle 15 is detected, and the differential value ≈ level LV0B. In such a case, determination unit 17B determines that the differential value output from differential processing unit 17A is less than first threshold value ThA based on differential graph Df11, and determines that component P is not sucked to the distal end portion of suction nozzle 15.

In addition, differential graph Df12 is a differential graph in a case where suction nozzle 15 is sucking component P and component P is normally sucked by suction nozzle 15. In differential graph Df12, between time t12 and time t13, the differential value is more than or equal to first threshold value ThA and is less than second threshold value ThB. In such a case, determination unit 17B determines that the differential value is more than or equal to first threshold value ThA and is less than second threshold value ThB based on differential graph Df12, and determines that component P is sucked to the distal end portion of suction nozzle 15 and component P is normally sucked.

Specifically, in a case where it is determined that the differential value corresponding to the thickness of component P is more than or equal to first threshold value ThA and is less than second threshold value ThB, determination unit 17B determines that thickness H1 of component P when surface P11 of component P is sucked by suction nozzle 15 is detected. Thus, in a case where it is determined that the differential value is more than or equal to first threshold value ThA and is less than second threshold value ThB, determination unit 17B determines that component P is normally sucked.

In addition, each of differential graphs Df13 and Df14 is a differential graph in a case where suction nozzle 15 is sucking component P and component P is not normally sucked by suction nozzle 15. In each of differential graphs Df13 and Df14, between time t12 and time t13, the differential value is more than or equal to second threshold value ThB. In such a case, determination unit 17B determines that the differential value is more than or equal to second threshold value ThB based on differential graphs Df13 and Df14, and determines that component P is sucked to the distal end portion of suction nozzle 15 and component P is not normally sucked.

Specifically, in a case where it is determined that the differential value corresponding to the thickness of component P is more than or equal to second threshold value ThB, determination unit 17B determines that thicknesses H2 and H3 of component P when surfaces (for example, surfaces P12 and P13, and the like) other than surface P11 of component P are sucked by suction nozzle 15 are detected. In the example illustrated in Fig. 5, a relationship in magnitude between the thickness of component P is H2 and H3 > H1.

For example, a differential graph in a case where suction nozzle 15 sucks surface P12 of component P becomes differential graph Df13A indicated by a solid line, and the differential value is more than or equal to second threshold value ThB. In addition, for example, a differential graph in a case where suction nozzle 15 sucks surface P13 of component P becomes differential graph Df13B indicated by a broken line, and the differential value is more than or equal to second threshold value ThB. Accordingly, in a case where it is determined that the differential value is more than or equal to second threshold value ThB, determination unit 17B determines that component P is sucked to the distal end portion of suction nozzle 15 and component P is not normally sucked (that is, a wrong surface is sucked by suction nozzle 15).

As described above, determination unit 17B can determine whether or not component P is normally sucked by suction nozzle 15 based on the differential value of the differential graph. Note that, it goes without saying that each of first threshold value ThA and second threshold value ThB used for the determination processing of the suction state of component P is an example and is not limited thereto.

For example, each of first threshold value ThA and second threshold value ThB is adaptively set to correspond to the shape and size of component P and the surface (that is, the thickness of component P with the distal end portion of suction nozzle 15 as a reference) of component P sucked by suction nozzle 15. For example, in a case where suction of surface P13 of component P is the normal suction, the second threshold value used for the determination processing of the suction state of component P may be threshold value ThAA illustrated in Fig. 5. In addition, in a case where suction of surface P13 of component P is the normal suction, and in a case where it is determined only whether or not component P is normally sucked by suction nozzle 15, mounting machine 100 may set at least one threshold value (for example, second threshold value ThB).

As described above, mounting machine 100 according to the first exemplary embodiment can detect component P sucked by the distal end portion of suction nozzle 15 based on the generated differential graph, and can determine (measure) whether or not the thickness of component P is thickness H1 of component P in a case where the component is normally sucked based on the differential value. Thus, mounting machine 100 according to the first exemplary embodiment can more accurately determine the suction state of component P even in a case where the suction nozzles have individual differences as illustrated in Fig. 4.

Next, a determination processing example of the suction posture (angle) of component P executed by mounting machine 100 according to the first exemplary embodiment will be described with reference to Fig. 6. Fig. 6 is a diagram for describing the determination processing example of the suction posture (angle) of component P of mounting machine 100 according to the first exemplary embodiment. Note that, in the example illustrated in Fig. 6, suction nozzle 15 and light source 14A are not illustrated. In addition, in the example illustrated in Fig. 6, the emission direction of light ray 14B is equal to an orientation of the arrow.

Determination unit 17B generates the differential graph by plotting the differential values output from the differential processing unit 17A in time series. Determination unit 17B determines whether or not component P is sucked to the distal end portion of suction nozzle 15 in a normal posture (angle) based on the generated differential graph.

Note that, the normal posture (angle) mentioned here is data regarding the posture (angle) of component P set to correspond to an orientation of component P mounted on board 13, and is included in, for example, the production data. Mounting machine 100 sucks and takes out component P from component supply unit 12 based on the posture (angle) of component P included in the production data, and conveys and mounts component P on board 13.

In each example of differential graphs Df21 to Df23 illustrated in Fig. 6, determination unit 17B executes the determination processing of the suction state of component P by determining whether or not a positive peak (that is, a maximum value of the differential value (first differential value)) of the differential value output from differential processing unit 17A is more than or equal to first threshold value ThA1 and is less than second threshold value ThB1 based on differential graphs Df21 to Df23.

In addition, determination unit 17B may execute the determination processing of the suction state of component P by using third threshold value ThA2 that is a threshold value equal to an absolute value of first threshold value ThA1 and used for determining the detection of component P based on a negative value of the differential value, and fourth threshold value ThB2 that is a threshold value equal to an absolute value of second threshold value ThB 1 and used for determining the detection of component P based on a negative value of the differential value. That is, third threshold value ThA2 is more than fourth threshold value ThB2.

Specifically, in a case where it is determined that a negative peak (that is, a minimum value of the differential value (second differential value)) of the differential value output from differential processing unit 17A is more than or equal to third threshold value ThA2, determination unit 17B determines that component P is not sucked to the distal end portion of suction nozzle 15. In a case where it is determined that a negative peak of the differential value is less than third threshold value ThA2 and is more than or equal to fourth threshold value ThB2, determination unit 17B determines that component P is sucked to the distal end portion of suction nozzle 15 and component P is normally sucked. In addition, in a case where it is determined that the negative peak of the differential value is less than fourth threshold value ThB2, determination unit 17B determines that component P is not normally sucked to the distal end portion of suction nozzle 15.

Note that, determination unit 17B may determine that component P is not normally sucked to the distal end portion of suction nozzle 15 only in a case where it is determined that the positive peak of the differential value output from differential processing unit 17A is more than or equal to first threshold value ThA1 and is less than second threshold value ThB1, and a negative peak of the differential value is less than third threshold value ThA2 and is more than or equal to fourth threshold value ThB2. Thus, since mounting machine 100 according to the first exemplary embodiment can measure the thickness of component P sucked by suction nozzle 15 with higher accuracy based on the generated differential graph, the mounting machine can determine whether or not component P is sucked in the normal suction posture with higher accuracy.

In addition, determination unit 17B measures a detection time of detected component P, and determines whether or not the detection time of component P is less than fifth threshold value ThC. Here, the detection time of component P is a time during which component P continues to shield light ray 14B. Note that, fifth threshold value ThC is a threshold value regarding the detection time of component P, and is a threshold value for determining whether or not component P is sucked in the normal suction posture by suction nozzle 15. The detection time of component P is, for example, a time between time t12 (first time) corresponding to the maximum value (first differential value) of the differential value and time t13 (second time) corresponding to the minimum value (second differential value) of the differential value (see Fig. 5).

Specifically, determination unit 17B can measure (calculate) the width of component P based on a moving speed of head 11 and detection time T21 of component P. In addition, here, a predetermined width when component P is sucked in the normal suction posture is defined by the moving speed of head 11 and fifth threshold value ThC (time). Accordingly, determination unit 17B can determine whether or not component P is sucked in the normal suction posture by determining whether or not measured width W1 of component P is less than fifth threshold value ThC.

In a case where it is determined that the detection time is less than fifth threshold value ThC, determination unit 17B determines that component P is sucked in the normal suction posture by suction nozzle 15. On the other hand, in a case where it is determined that the detection time is not less than fifth threshold value ThC, determination unit 17B determines that component P is not sucked in the normal suction posture by suction nozzle 15.

Determination unit 17B outputs the determination result to output unit 19 or management computer 21, and stores the determination result in memory 18. Note that, various functions realized by differential processing unit 17A or determination unit 17B described above may be executed by management computer 21.

Hereinafter, the determination processing example of the suction posture (angle) of component P by determination unit 17B will be specifically described by comparing differential graphs Df21 to Df23 illustrated in Fig. 6. Note that, the normal suction in the example illustrated in Fig. 6 is, for example, a state where surface P21 of component P is sucked by suction nozzle 15 and surface P21A is detected by measurement system 14. Differential graph Df21 is an example of the differential graph in a case where component P is sucked in the normal suction posture by suction nozzle 15. Each of differential graphs Df22 and Df23 is an example of the differential graph in a case where component P is not sucked in the normal suction posture by suction nozzle 15.

A vertical axis of each of differential graphs Df21 to Df23 indicates the differential value output from differential processing unit 17A. A horizontal axis of each of differential graphs Df21 to Df23 indicates time. In addition, level LV0C indicates that the differential value output from the differential processing unit 17A is 0 (zero).

In differential graph Df21 as an example of the differential graph in a case where component P is normally sucked by suction nozzle 15, detection time T21 of component P is less than fifth threshold value ThC. In such a case, determination unit 17B determines that detection time T21 of component P is less than fifth threshold value ThC based on differential graph Df21, and determines that component P is sucked in the normal suction posture by suction nozzle 15. Specifically, in a case where it is determined that detection time T21 of component P is less than fifth threshold value ThC, determination unit 17B determines that the component is sucked at an angle (posture) at which surface P21A of component P faces light source 14A.

In addition, in each of differential graphs Df22 and Df23 as an example of the differential graph in a case where component P is normally sucked by suction nozzle 15, detection times T22 and T23 of component P are more than or equal to fifth threshold value ThC. In such a case, determination unit 17B determines that detection times T22 and T23 of component P are not less than fifth threshold value ThC based on differential graphs Df22 and Df23, and determines that component P is not sucked in the normal suction posture by suction nozzle 15. Specifically, in a case where it is determined that detection times T22 and T23 of component P are not less than fifth threshold value ThC, determination unit 17B determines that component P is not sucked at an angle (posture) at which the component faces light source 14A.

In addition, determination unit 17B may measure the suction posture (angle) of component P with respect to light source 14A based on the information (for example, shape, size, and the like) regarding component P, the moving speed of head 11, and detection time T22 of component P. In such a case, determination unit 17B calculates width W2 of component P based on the moving speed of head 11 and detection time T22 of component P. Determination unit 17B measures the suction posture (angle) of component P with respect to light source 14A based on calculated width W2 of component P and the information (for example, shape, size, and the like) regarding component P. Further, determination unit 17B can measure the thickness of component P, and can estimate that surface P22A is detected by measurement system 14 based on the measured thickness of component P and the suction posture (angle) of component P with respect to light source 14A.

Similarly, determination unit 17B calculates width W3 of component P based on the moving speed of head 11 and detection time T23 of component P. Determination unit 17B measures the suction posture (angle) of component P with respect to light source 14A based on calculated width W3 of component P and the information (for example, shape, size, and the like) regarding component P. Further, determination unit 17B can measure the thickness of component P, and can estimate that surfaces P23A and P23B are detected by measurement system 14 based on the measured thickness of component P and the suction posture (angle) of component P with respect to light source 14A.

As described above, mounting machine 100 according to the first exemplary embodiment can determine whether or not component P is sucked in the normal suction posture by suction nozzle 15 based on the generated differential graph.

Note that, in the example illustrated in Fig. 6, the number of threshold values for determining whether or not component P is sucked in the normal suction posture by suction nozzle 15 is one (fifth threshold value ThC), but is not limited thereto. For example, in a case where the normal suction posture is a state where surface P22 of component P is sucked by suction nozzle 15 and surface P22A is detected by measurement system 14, each of fifth threshold value ThC and sixth threshold value ThD may be set as the above-described threshold value. In such a case, in a case where it is determined that the detection time of detected component P is more than or equal to fifth threshold value ThC and is less than sixth threshold value ThD, determination unit 17B determines that component P is sucked in the normal suction posture. That is, in this case, determination unit 17B determines that the suction posture of component P is not defective. On the other hand, in a case where it is determined that the detection time of detected component P is less than fifth threshold value ThC or is more than or equal to sixth threshold value ThD, determination unit 17B determines that component P is not sucked in the normal suction posture.

Note that, differential processing unit 17A according to the first exemplary embodiment may generate the differential graph in which the absolute value is taken for each differential value of the computed IV converted values and may output the differential graph to determination unit 17B. In such a case, determination unit 17B may execute the determination processing of the suction state of component P based on the differential value obtained by taking the absolute value and each of first threshold value ThA1 and second threshold value ThB1. For example, in a case where it is determined that two peaks of the differential value obtained by taking the absolute value are more than or equal to first threshold value ThA1 and are less than second threshold value ThB1, determination unit 17B determines that component P is not normally sucked to the distal end portion of suction nozzle 15.

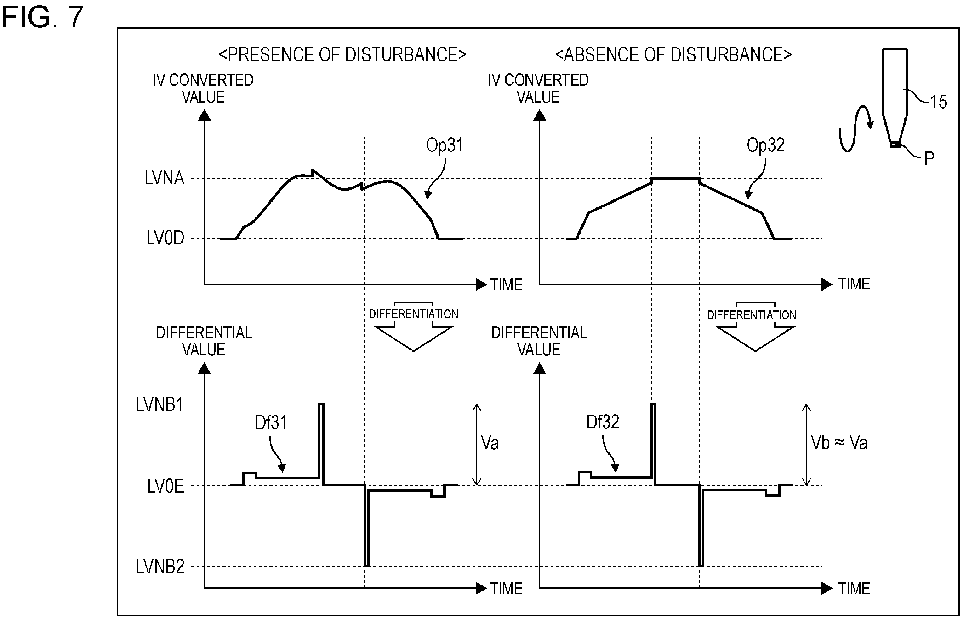

Next, a difference between the IV conversion graph and the differential graph depending on the presence or absence of disturbance will be described with reference to Fig. 7. Fig. 7 is a diagram for describing a comparative example of the IV conversion graph and the differential graph depending on the presence or absence of disturbance.

Each of IV conversion graph Op31 and differential graph Df31 illustrated in Fig. 7 illustrates an example of a graph generated in a case where there is a disturbance. In addition, each of IV conversion graph Op32 and differential graph Df32 illustrates an example of a graph generated in a case where there is no disturbance. Here, light shielding level LV0D indicates an IV converted value obtained in a case where light ray 14B is not shielded by suction nozzle 15. Detection level LVNA indicates an IV converted value corresponding to the thickness (height) of component P sucked by suction nozzle 15. Level LV0E indicates a differential value obtained in a case where light ray 14B is not shielded by suction nozzle 15. Detection levels LVNB1 and LVNB2 indicate differential values corresponding to the thickness (height) of component P sucked by suction nozzle 15.

The disturbance is, for example, vibration at the time of driving (moving) head 11. This vibration appears as, for example, a sine wave having a cycle in the order of kHz on the electric signal generated by photoelectric conversion element 14D. Thus, it is difficult for mounting machine 100 to measure the thickness of component P sucked to the distal end portion of suction nozzle 15 based on IV conversion graph Op31 generated by plotting the IV converted values converted by current-voltage conversion unit 14E in time series.

Thus, mounting machine 100 according to the first exemplary embodiment generates differential graph Df31 by differentiating the IV converted values by differential processing unit 17A and plotting the differentiated differential values in time series. Note that, here, differential processing unit 17A executes the differential processing in a unit (MHz order) smaller than a unit (kHz order) of a cycle of the disturbance (vibration). That is, differential processing unit 17A differentiates the IV converted value at a frequency (second frequency) more than or equal to 1 MHz and is less than 1 GHz. Thus, mounting machine 100 according to the first exemplary embodiment can generate differential graph Df31 obtained by excluding the disturbance (vibration). Note that, in the example illustrated in Fig. 7, differential graph Df31 becomes differential value Va in a time zone in which component P passes through light ray 14B.

In a case where there is no disturbance, mounting machine 100 according to the first exemplary embodiment also generates differential graph Df32 by differentiating the IV converted values with a cycle in the order of MHz smaller than a cycle of disturbance (vibration) in the order of kHz and plotting the differentiated differential values in time series. Note that, in the example illustrated in Fig. 7, differential graph Df32 becomes differential value Vb in a time zone in which component P passes through light ray 14B.

In each of differential graphs Df31 and Df32 generated as described above, differential values Va and Vb in the time zone in which component P passes through light ray 14B are substantially equal. Accordingly, mounting machine 100 according to the first exemplary embodiment can obtain differential graphs Df31 and Df32 in which fluctuation in the IV converted value due to the disturbance (vibration) is removed by differentiating the IV converted value output from current-voltage conversion unit 14E with the cycle in the order of MHz smaller than the cycle of the disturbance (vibration) in the order of kHz. Thus, mounting machine 100 according to the first exemplary embodiment can measure the thickness of component P sucked by the distal end portion of suction nozzle 15 with higher accuracy even in a case where there is a disturbance, and can determine the suction state of component P with higher accuracy.

As described above, mounting machine 100 according to exemplary embodiment 1 includes head 11 that sucks components P at the distal ends portions of the plurality of suction nozzles 15 and mounts components P on board 13, measurement system 14 (an example of the sensor) that includes light source 14A and photoelectric conversion element 14D (an example of the light receiver) that receives light ray 14B emitted from light source 14A, and emits light ray 14B to the distal end portion of suction nozzle 15 to output the IV converted value (light intensity) of light ray 14B received by photoelectric conversion element 14D, and processor 17 (an example of the controller) that differentiates the IV converted value of light ray 14B output from measurement system 14 and determines whether or not the suction state of component P sucked by the distal end portion of suction nozzle 15 passing through light ray 14B is defective based on the differentiated differential value. In a case where it is determined that the differential value is more than or equal to first threshold value ThA and is less than second threshold value ThB more than first threshold value ThA, processor 17 determines that the suction state of component P is not defective (that is, is a normal suction state).

Thus, mounting machine 100 according to the first exemplary embodiment can determine the suction state of component P by excluding the individual difference for each suction nozzle 15 by using the differential value obtained by excluding the individual difference by differentiating the IV converted value even in a case where there is the individual difference in each of the plurality of suction nozzles 15 included in head 11 and the suction height of component P fluctuates. Accordingly, mounting machine 100 can determine the suction state of component P with higher accuracy. In addition, here, the magnitude of the differential value corresponds to the thickness of component P in the Z-direction. Accordingly, mounting machine 100 can determine whether or not the thickness of component P sucked by suction nozzle 15 by the differential value is a thickness of component P in a correct suction posture indicated by first threshold value ThA or more and less than second threshold value ThB.

In addition, as described above, in a case where it is determined that the differential value is less than first threshold value ThA, processor 17 in mounting machine 100 according to the first exemplary embodiment determines that component P is not sucked to the distal end portion of suction nozzle 15, and generates and outputs a notification indicating that the suction state of component P is defective (that is, is not the normal suction state). Thus, mounting machine 100 according to the first exemplary embodiment can determine whether or not component P is detected based on the differential value. In a case where it is determined that component P is not detected, mounting machine 100 can determine that component P is not sucked by suction nozzle 15, and can generate and output a notification indicating that the suction state of component P is not normal.

In addition, as described above, in a case where it is determined that the differential value is more than or equal to second threshold value ThB, processor 17 in mounting machine 100 according to the first exemplary embodiment generates and outputs the notification indicating that the suction state of component P is defective (that is, is not the normal suction state). Thus, mounting machine 100 according to the first exemplary embodiment can determine the suction state of component P based on the height of component P based on the differential value. In a case where it is determined that the differential value is more than or equal to second threshold value ThB, mounting machine 100 can determine that the suction surface of component P sucked by suction nozzle 15 is wrong, and can generate and output a notification indicating that the suction state of component P is defective.

In addition, as described above, processor 17 in mounting machine 100 according to the first exemplary embodiment measures detection times (examples of the time zone, for example, detection times T21, T22, and T23 illustrated in Fig. 6) in which the differential value is more than or equal to first threshold value ThA and is less than second threshold value ThB, and determines the suction posture of component P based on the measured detection time. Thus, mounting machine 100 according to the first exemplary embodiment can determine the suction posture of component P based on the width of component P corresponding to the detection time.

In addition, as described above, in a case where it is determined that a length of the detection time is less than a predetermined time (an example of fifth threshold value ThC), processor 17 in mounting machine 100 according to the first exemplary embodiment determines that the suction posture of component P is not defective. Thus, mounting machine 100 according to the first exemplary embodiment can determine whether or not the detection time is less than or equal to an upper limit value of the width of component P at the time of the correct suction posture indicated by fifth threshold value ThC. Mounting machine 100 can determine that the suction posture of component P is not defective (that is, is the normal suction posture) in a case where it is determined that the detection time is less than fifth threshold value ThC.

In addition, as described above, in a case where it is determined that the length of the detection time is not less than the predetermined time (an example of fifth threshold value ThC), processor 17 in mounting machine 100 according to the first exemplary embodiment determines that the suction posture of component P is defective, and generates and outputs the notification indicating that the suction state of component P is defective. Thus, mounting machine 100 according to the first exemplary embodiment can determine whether or not the detection time is less than or equal to an upper limit value of the width of component P at the time of the correct suction posture indicated by fifth threshold value ThC. In a case where it is determined that the detection time is not less than fifth threshold value ThC, mounting machine 100 can determine that there is an error in the suction surface, the suction angle, or the like, and the suction posture of component P is defective, and can generate and output the notification indicating that the suction posture of component P is defective (that is, is not the normal suction posture).

In addition, as described above, in mounting machine 100 according to the first exemplary embodiment, a second cycle in which processor 17 differentiates the light intensity is smaller than a first cycle in which the light intensity is output from measurement system 14. Thus, mounting machine 100 according to the first exemplary embodiment can determine the suction state of component P based on the differential value obtained by excluding the change in the IV converted value due to the disturbance by differentiating the IV converted value even in a case where the IV converted value changes due to the disturbance (for example, vibration) at the time of driving head 11.

In addition, as described above, in mounting machine 100 according to the first exemplary embodiment, the first cycle is in the order of kHz. The second cycle is in the order of MHz. Thus, mounting machine 100 according to the first exemplary embodiment can more effectively exclude the change in the IV converted value due to the disturbance at the time of driving head 11.

As described above, there is provided the suction state determination method executed by management computer 21 (an example of a terminal device) including one or more computers (for example, a processor included in management computer 21) that sucks components P at the distal end portions of the plurality of suction nozzles 15 and is connected to communicate with mounting machine 100 mounted on board 13. The suction state determination method includes acquiring the IV converted value (an example of the light intensity) of light ray 14B emitted to the distal end portion of suction nozzle 15 and received by photoelectric conversion element 14D (an example of the light receiver), differentiating the acquired IV converted value of light ray 14B, and determining that the suction state of component P sucked to the distal end portion of suction nozzle 15 passing through light ray 14B is not defective (that is, is the normal suction posture) in a case where the differentiated differential value is more than or equal to first threshold value ThA and is less than second threshold value ThB more than first threshold value ThA.

As a result, management computer 21 according to the first exemplary embodiment can execute the determination processing of the suction state of component P obtained by excluding the individual difference for each suction nozzle 15 based on the IV converted value output from mounting machine 100.

Although various exemplary embodiments have been described above with reference to the accompanying drawings, the present disclosure is not limited to such examples. It is obvious that those skilled in the art can conceive various changes, modifications, substitutions, additions, deletions, and equivalents within the scope described in the claims, and it is understood that these also belong to the technical scope of the present disclosure. In addition, the constituent elements in the above-described various exemplary embodiments may be arbitrarily combined without departing from the gist of the invention.

### INDUSTRIAL APPLICABILITY

The present disclosure is useful for presenting the mounting machine and the suction state determination method capable of determining the suction state of the component sucked to the nozzle with higher accuracy.

### REFERENCE MARKS IN THE DRAWINGS

11: head
12: component supply unit
13: board
14: measurement system
14A: light source
14B: light ray
14C: slit
14D: photoelectric conversion element
14E: current-voltage conversion unit
15, 15A, 15B: suction nozzle
17: processor
17A: differential processing unit
17B: determination unit
18: memory
18A: threshold value
19: output unit
21: management computer
100: mounting machine
P: component

## Claims

1. A mounting machine comprising:
a head that includes a suction nozzle, the head being configured to suck a component at a distal end portion of the suction nozzle and mount the component on a board;
a sensor that includes a light source and a light receiver, the light source being configured to emit a light ray to the distal end portion of the suction nozzle, the light receiver being configured to receive the light ray emitted from the light source, the sensor being configured to output light intensity of the light ray received by the light receiver; and
a controller that computes a first differential value by differentiating the light intensity of the light ray output from the sensor, and determines whether or not a suction state of the component sucked to the distal end portion of the suction nozzle when the suction nozzle passes through the light ray is defective based on the computed first differential value,
wherein the controller determines that the suction state of the component is not defective when the first differential value is more than or equal to a first threshold value and is less than a second threshold value more than the first threshold value.

2. The mounting machine according to Claim 1, wherein the controller determines that the component is not sucked to the distal end portion of the suction nozzle and generates and outputs a notification indicating that the suction state of the component is defective when it is determined that the first differential value is less than the first threshold value.

3. The mounting machine according to Claim 1, wherein the controller generates and outputs a notification indicating that the suction state of the component is defective when it is determined that the first differential value is more than or equal to the second threshold value.

4. The mounting machine according to Claim 1, wherein
the controller computes a second differential value by differentiating the light intensity,
the first differential value is a maximum value of a differential value of the light intensity in a predetermined period,
the second differential value is a minimum value of the differential value of the light intensity in the predetermined period, and
the controller
measures a detection time between a first time corresponding to the first differential value and a second time corresponding to the second differential value, and
determines a suction posture of the component based on the measured detection time.

5. The mounting machine according to Claim 4, wherein the controller determines that the suction posture of the component is not defective when it is determined that a length of the detection time is less than a predetermined time.

6. The mounting machine according to Claim 4, wherein the controller determines that the suction posture of the component is defective and generates and outputs a notification indicating that the suction state of the component is defective when it is determined that a length of the detection time is not less than a predetermined time.

7. The mounting machine according to Claim 4, wherein the controller determines that the suction posture of the component is not defective when it is determined that a length of the detection time is more than or equal to a first predetermined time and is less than a second predetermined time.

8. The mounting machine according to Claim 1, wherein
the sensor outputs the light intensity at a first frequency, and
the controller differentiates the light intensity at a second frequency higher than the first frequency.

9. The mounting machine according to Claim 8, wherein
the first frequency is more than or equal to 1 kHz and is less than 1 MHz, and
the second frequency is more than or equal to 1 MHz and is less than 1 GHz.

10. The mounting machine according to Claim 1, wherein the head includes a plurality of the suction nozzles.

11. The mounting machine according to Claim 10, wherein
the plurality of suction nozzles are aligned in a direction perpendicular to a direction in which the light source emits the light ray, and
the head moves in the direction in which the plurality of suction nozzles are aligned.

12. A suction state determination method executed by a terminal device including one or more computers connected to communicate with a mounting machine, the mounting machine being configured to suck a component at a distal end portion of a suction nozzle and mount the component on a board, the method comprising:
acquiring light intensity of a light ray emitted to the distal end portion of the suction nozzle and received by a light receiver;
computing a differential value by differentiating the acquired light intensity of the light ray; and
determining that a suction state of the component sucked to the distal end portion of the suction nozzle when the suction nozzle passes through the light ray is not defective when it is determined that the computed differential value is more than or equal to a first threshold value and is less than a second threshold value more than the first threshold value.
